# EUROPEAN PATENT APPLICATION

(11) **EP 4 545 949 A1**
(43) Date of publication of application: **30.04.2025**
(21) Application number: 23826829.6
(22) Date of filing: 12.05.2023
(51) Int. Cl.: G01N 21/956, G01N 21/84, H05K 13/08

(54) **INSPECTING DEVICE**

(30) Priority: 22.06.2022 JP 2022099961
(71) Applicant: Saki Corporation, Tokyo 135-0051 (JP)
(72) Inventor: IWASE, Atsushi, Tokyo 135-0051 (JP); TAKEUCHI, Taro, Tokyo 135-0051 (JP)
(74) Representative: Plougmann Vingtoft a/s
(86) International application number: PCT/JP2023/017820
(87) International publication number: WO 2023/248641

(57) **Abstract**

To provide an inspection device capable of reducing time required for inspection (takt time) by managing processing of loading and imaging an inspection object and processing of inspection and count with different conveyance units. An inspection device 10 includes an imaging unit 20, a conveying unit 40, and a controlling unit 30, the conveying unit 40 includes first and second conveyance units 41 and 42, an operation of each of the conveyance units can be individually controlled by the controlling unit 30, the first conveyance unit 41 is arranged in an imaging area, and the second conveyance unit 42 is arranged in an inspection/count area (standby area). In addition, when an image of an inspection object 12 having been moved to the imaging area by the first conveyance unit 41 is being captured, the controlling unit 30 causes the second conveyance unit 42 to unload another inspection object from the inspection/count area.

## Description

### Technical Field

The present invention relates to an inspection device for inspecting an outer appearance of an inspection object.

### Background Art

In an inspection device that inspects an outer appearance of a substrate (inspection object) on which electronic components and the like are mounted, a configuration is adopted such that a single conveyance unit performs everything from loading the substrate to the inspection device, imaging, inspection, and count, to unloading the substrate (refer to Patent Literature 1).

### Citation List

### Patent Literature

Patent Literature 1: Japanese Patent Laid-Open No. 2014-010082

### Summary of Invention

### Technical Problem

However, in such an inspection device, since the substrate cannot be carried out until processing of inspection and count is completed, there is a problem in that an inspection of a next substrate cannot be executed, standby time by the next substrate arises and, consequently, a throughput of the inspection device declines.

The present invention has been made in consideration of such problems and an object thereof is to provide an inspection device capable of reducing time required for inspection (takt time) by configuring a conveying unit that conveys an inspection object in the inspection device with a plurality of conveyance units arrayed in series and by managing processing of loading and imaging a substrate (inspection object) and processing of inspection and count with different conveyance units.

### Solution to Problem

In order to solve the problem described above, a first aspect of an inspection device according to the present invention includes: an image unit that acquires image data of an inspection object; a conveying unit that moves the inspection object; and a control unit that controls operations of the image unit and the conveying unit, wherein the conveying unit includes at least two conveyance units connected in series in a moving direction in which the inspection object is moved, an operation of each of the conveyance units can be individually controlled by the control unit, at least one conveyance unit of the conveyance units is a first conveyance unit arranged in an imaging area where image data can be acquired by the image unit, at least one conveyance unit of the remaining conveyance units is a second conveyance unit arranged in a standby area in front of or behind the imaging area in the moving direction, and when the control unit is individually controlling the conveyance units and the image unit is capturing an image of the inspection object having been moved to the imaging area by the first conveyance unit, the control unit causes the second conveyance unit to load another inspection object into the standby area or unload another inspection object from the standby area.

In addition, in order to solve the problem described above, a second aspect of the inspection device according to the present invention includes: an image unit that acquires image data of an inspection object; a conveying unit that moves the inspection object; and a control unit that controls operations of the image unit and the conveying unit, wherein the conveying unit includes at least two conveyance units connected in series in a moving direction in which the inspection object is moved, an operation of each of the conveyance units can be individually controlled by the control unit, at least two conveyance units of the conveyance units are a first conveyance unit and a second conveyance unit arranged in an imaging area where image data can be acquired by the image unit, and when the control unit is individually controlling the conveyance units and the image unit is capturing an image of the inspection object at one of the first conveyance unit and the second conveyance unit, the control unit causes the other of the first conveyance unit and the second conveyance unit to move another inspection object.

### Advantageous Effect of Invention

The present invention can provide an inspection device capable of reducing time required for inspection (takt time) by managing processing of loading and imaging a substrate (inspection object) and processing of inspection and count with different conveyance units.

### Brief Description of Drawings

[Figure 1] Figure 1 is an explanatory diagram for describing a configuration of an inspection device.
[Figure 2] Figure 2 is an explanatory diagram for describing a configuration of a conveying unit according to a first embodiment of the inspection device described above.
[Figure 3] Figure 3 is an explanatory diagram for describing a flow of an inspection using the conveying unit according to the first embodiment.
[Figure 4] Figure 4 is an explanatory diagram for describing a configuration of a conveying unit according to a second embodiment of the inspection device described above.
[Figure 5] Figure 5 is an explanatory diagram for describing a control method of the conveying unit according to the second embodiment, in which (a) shows a standard mode, (b) shows a case where imaging is performed by a first conveyance unit in a 2-buffer mode, and (c) shows a case where imaging is performed by a second conveyance unit in the 2-buffer mode.
[Figure 6] Figure 6 is an explanatory diagram for describing a configuration of a conveying unit according to a third embodiment of the inspection device described above.

### Description of Embodiments

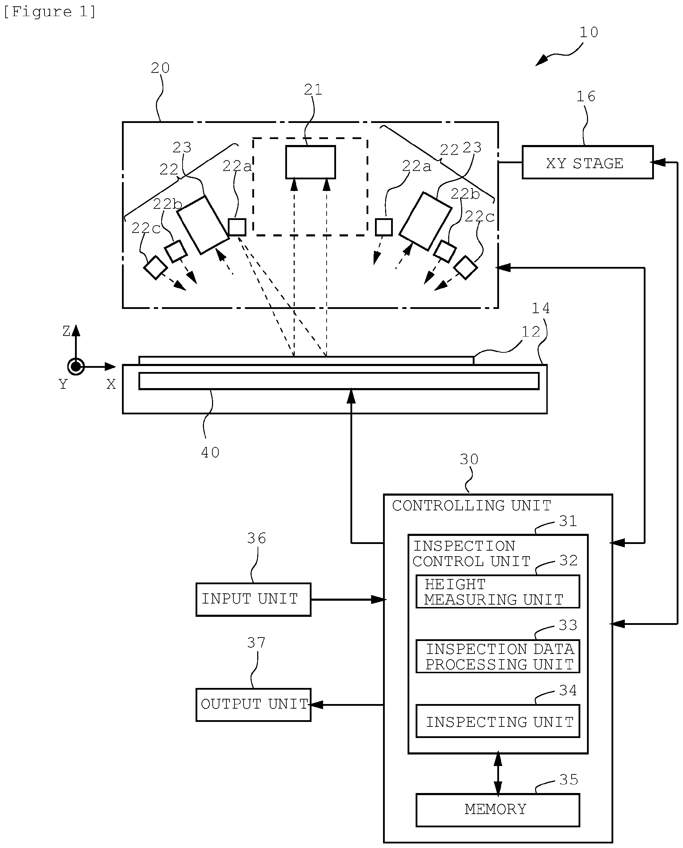

Hereinafter, preferred embodiments of the present invention will be described with reference to the drawings. First, a configuration of an inspection device 10 according to the present embodiment will be described using Figure 1. The inspection device 10 is a device for inspecting an inspection object 12 using an inspection object image obtained by imaging of the inspection object 12. For example, the inspection object 12 is an electronic circuit board to which a large number of electronic components are mounted. The inspection device 10 determines whether a mounting state of the electronic components is good or bad based on the inspection object image. The inspection is usually performed on a plurality of inspection items for each component. An inspection item is an item that requires good/bad to be determined. For example, inspection items include inspection items with respect to component arrangement such as an absence, a misalignment, a reversal of polarity, and the like of a component itself and inspection items with respect to a connection between the component and a substrate such as a soldering condition and lifting of a lead pin of the component.

The inspection device 10 is configured to include an inspection table 14 for holding the inspection object 12, an imaging unit 20 that illuminates and captures an image of the inspection object 12, an XY stage 16 that moves the imaging unit 20 with respect to the inspection table 14, and a controlling unit 30 for controlling the imaging unit 20 and the XY stage 16 and executing an inspection of the inspection object 12. For convenience of description, as shown in Figure 1, an inspection object arrangement surface of the inspection table 14 is considered an XY plane and a direction perpendicular to the arrangement surface (in other words, an imaging direction by a first image unit 21 that constitutes the imaging unit 20 (an optical axis direction of an optical system of the first image unit 21)) is considered a Z direction.

The imaging unit 20 is attached to a mobile table (not illustrated) of the XY stage 16 and is movable in each of an X direction and a Y direction by the XY stage 16. For example, the XY stage 16 is a so-called H-shaped XY stage. Therefore, the XY stage 16 is equipped with a Y driving unit that moves the mobile table in the Y direction along a Y-direction guide extending in the Y direction, and two X-direction guides and an X driving unit configured to support the Y-direction guide at both ends thereof and enable the mobile table and the Y-direction guide to move in the X direction. The XY stage 16 may be further equipped with a Z movement mechanism to move the imaging unit 20 in the Z direction or further equipped with a rotation mechanism to rotate the imaging unit 20. The inspection device 10 may be further equipped with an XY stage that enables the inspection table 14 to move, in which case the XY stage 16 that moves the imaging unit 20 may be omitted. In addition, a linear motor or a ball screw can be used as the X driving unit and the Y driving unit. Furthermore, the XY stage 16 may be constituted of one axis in the X direction and one axis in the Y direction.

The imaging unit 20 is configured to include the first image unit 21 being a main camera that captures images of an inspection surface (substrate surface) of the inspection object 12 from a vertical direction (Z-axis direction), an illuminating unit 22, and a second image unit 23 being a side camera that captures images of the inspection surface (substrate surface) of the inspection object 12 from a diagonal direction (at an angle that differs from the Z axis). This is done to increase inspection accuracy by photographing and inspecting the inspection object 12 from two directions. In the inspection device 10 according to the present embodiment, the first image unit 21, the illuminating unit 22, and the second image unit 23 may be configured as an integrated imaging unit 20. In the integrated imaging unit 20, relative positions of the first image unit 21, the illuminating unit 22, and the second image unit 23 may be fixed or each unit may be configured so as to be relatively movable. Alternatively, the first image unit 21, the illuminating unit 22, and the second image unit 23 may be separate bodies and configured so as to be separately movable. In addition, the imaging unit 20 may be provided with a projection unit that projects a pattern to the inspection surface of the inspection object 12. For example, when adopting a configuration in which a stripe pattern whose brightness varies according to a sine curve is projected from the projection unit to the inspection object 12, the controlling unit 30 can create a height map of the inspection object 12 by a PMP (Phase Measurement Profilometry) method from an image of the inspection object 12 on which the stripe pattern has been projected.

The first image unit 21 includes an image sensor that generates two-dimensional image data of an object and an optical system (for example, a lens) for forming an image on the image sensor. The first image unit 21 is, for example, a CMOS camera. A maximum visual field of the first image unit 21 may be smaller than an inspection object placement area of the inspection table 14. In this case, the first image unit 21 captures an entire image of the inspection object 12 by dividing the image into a plurality of partial images. The controlling unit 30 controls the XY stage 16 so that the first image unit 21 is moved to a next imaging position each time the first image unit 21 captures a partial image. The controlling unit 30 generates an entire image (full substrate image data) of the inspection object 12 by compositing the pieces of partial image data outputted from the first image unit 21.

The first image unit 21 may be equipped with an image sensor that generates one-dimensional image data such as a line sensor instead of a two-dimensional image sensor. In this case, by scanning the inspection object 12 with the first image unit 21, entire image data of the inspection object 12 can be acquired.

The illuminating unit 22 is configured to project illumination light for imaging by the first image unit 21 and the second image unit 23 to a surface of the inspection object 12. The illuminating unit 22 is equipped with one or a plurality of light sources that emit light of a wavelength or a wavelength range selected from a wavelength range detectable by the image sensors of the first image unit 21 and the second image unit 23. The illumination light is not limited to visible light and ultraviolet light, X-rays, and the like may be used. When the light source is provided in plurality, each light source is configured to project light (for example, red, blue, and green) of a different wavelength to the surface of the inspection object 12 from a different projection angle.

In the inspection device 10 according to the present embodiment, the illuminating unit 22 is a lateral illuminating source that projects illumination light to the inspection surface of the inspection object 12 from a diagonal direction and, in the present embodiment, the illuminating unit 22 is equipped with an upper light source 22a, a middle light source 22b, and a lower light source 22c. In the inspection device 10 according to the present embodiment, each of the lateral illuminating sources 22a, 22b, and 22c is a ring illuminating source and is configured to surround the optical axis of the first image unit 21 and obliquely project illumination light to the inspection surface of the inspection object 12. Each of the lateral illuminating sources 22a, 22b, and 22c may be configured by having a plurality of light sources arranged in an annular shape. In addition, each of the upper light source 22a, the middle light source 22b, and the lower light source 22c that are lateral illuminating sources is configured to project illumination light at a different angle with respect to the inspection surface.

In addition, the second image unit 23 is configured to capture images of the inspection surface (substrate surface) of the inspection object 12 from a diagonal direction. For example, the second image unit 23 is also a CMOS camera in a similar manner to the first image unit 21.

While the second image unit 23 is provided between the upper light source 22a and the middle light source 22b in the illustrated example, the arrangement of the second image unit 23 is not limited thereto and, for example, the second image unit 23 may be provided outside the lower light source 22c.

In addition, the inspection table 14 is provided with a conveying unit 40 that carries the inspection object 12 delivered from an upstream step of the inspection device 10 into an area where imaging by the imaging unit 20 is performed (hereinafter, referred to as an "imaging area"), moves the inspection object 12 after imaging has been performed to an area where inspection and count are performed (hereinafter, referred to as an "inspection/count area"), and further carries out the inspection object 12 after count has been performed and delivers the inspection object 12 to a next step. Since the inspection object 12 having been moved to the inspection/count area is standing by for processing of inspection and count to be completed, the inspection/count area may be referred to as a standby area. The conveying unit 40 is also provided with a clamping mechanism for fixing the inspection object 12 when imaging is performed by the imaging unit 20 in the imaging area. Operations of the conveying unit 40 are controlled by the controlling unit 30. A detailed description of the conveying unit 40 will be given later.

The controlling unit 30 shown in Figure 1 comprehensively controls the entire present apparatus, and while the controlling unit 30 can be implemented by a CPU, a coprocessor such as a GPU (Graphics Processing Unit) or an FPU (Floating-point Processing Unit/Floating-Point Unit), a memory, or other LSI of any computer as hardware or by a program loaded onto a memory as software, functional blocks that are realized by cooperation between such hardware and software are depicted herein. Therefore, the functional blocks can be realized in various ways by hardware alone, software alone, or a combination thereof.

Figure 1 shows an example of a configuration of the controlling unit 30. The controlling unit 30 is configured to include an inspection control unit 31 and a memory 35 that is a storage unit. The inspection control unit 31 is configured to include a height measuring unit 32, an inspection data processing unit 33, and an inspecting unit 34. In addition, the inspection device 10 is equipped with an input unit 36 for receiving input from a user or another apparatus and an output unit 37 for outputting information related to an inspection, in which case the input unit 36 and the output unit 37 are respectively connected to the controlling unit 30. For example, the input unit 36 includes input means such as a mouse and a keyboard for receiving input from the user and communicating means for communicating with another apparatus. The output unit 37 includes known output means such as a display or a printer.

The inspection control unit 31 is configured to execute various kinds of control processing for inspection based on input from the input unit 36 and inspection-related information stored in the memory 35. The inspection-related information includes two-dimensional image data of the inspection object 12, a height map of the inspection object 12, and substrate inspection data. Prior to an inspection, the inspection data processing unit 33 creates substrate inspection data using two-dimensional image data and a height map of an inspection object 12 that is guaranteed to pass all inspection items. The inspecting unit 34 executes the inspection based on the created substrate inspection data and the two-dimensional image data and the height map of the inspection object 12 to be inspected.

Substrate inspection data is inspection data that is created for each substrate variety. Substrate inspection data is, so to speak, a collection of inspection data for each component mounted on the substrate. The inspection data of each component includes inspection items required for that component, an inspection window that is an inspection area on an image for each inspection item, and inspection criteria that is inspection information associated with the inspection window and that serves as criteria for determining whether each inspection item is good or bad. One or a plurality of inspection windows are set with respect to each inspection item. For example, in an inspection item of determining whether soldering of a component is good or bad, usually, the same number of inspection windows as the number of soldering areas of the component are set in an arrangement corresponding to an arrangement of the soldering areas. In addition, with respect to an inspection item that uses image data obtained by subjecting image data of the inspection object (partial image data or full substrate image data) to predetermined image processing, contents of the image processing is also included in the inspection data.

The inspection data processing unit 33 sets each item of inspection data according to the substrate as substrate inspection data creation processing. For example, the inspection data processing unit 33 automatically sets a position and a size of each inspection window for each inspection item so as to conform to a component layout of the substrate. The inspection data processing unit 33 may receive input by the user with respect to a part of the items in inspection data. For example, the inspection data processing unit 33 may accept tuning of inspection criteria by the user. The inspection criteria may be set using height information.

The inspection control unit 31 executes imaging processing of the inspection object 12 as preprocessing of creation of substrate inspection data. As the inspection object 12, an inspection object having passed all inspection items is used. As described above, imaging processing is performed by controlling relative movement of the imaging unit 20 and the inspection table 14 while illuminating the inspection object 12 with the illuminating unit 22, sequentially capturing partial images of the inspection object 12 with the first image unit 21 and the second image unit 23, and outputting partial image data. A plurality of partial images are captured so as to cover the entire inspection object 12. The inspection control unit 31 composites the plurality of pieces of partial image data and generates full substrate image data that is an image including the entire inspection surface of the inspection object 12. The inspection control unit 31 stores the partial image data and the full substrate image data in the memory 35.

Hereinafter, the conveying unit 40 provided in the inspection device 10 according to the present embodiment will be described.

### (First embodiment)

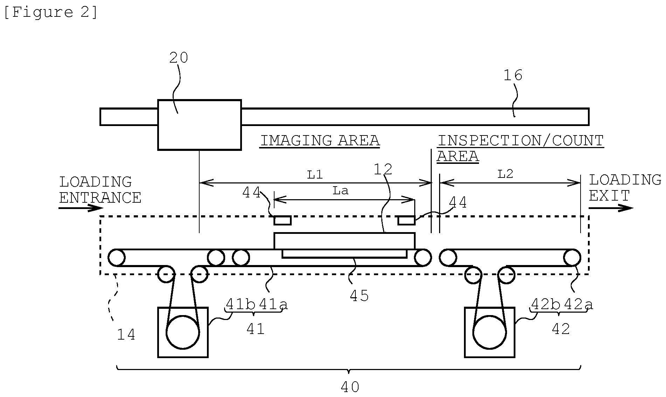

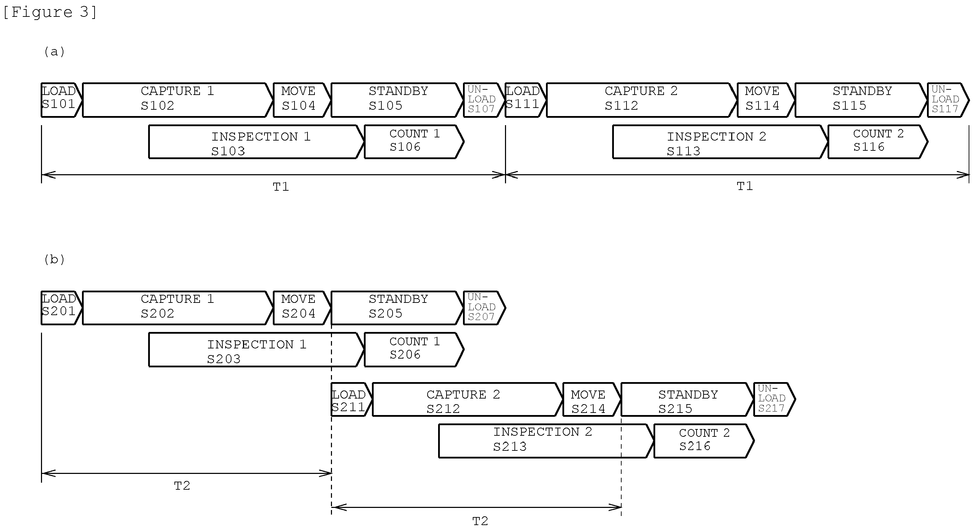

First, a first embodiment of the conveying unit 40 will be described with reference to Figures 2 and 3. As shown in Figure 2, the conveying unit 40 is constituted of a first conveyance unit 41 and a second conveyance unit 42 arranged in series from a loading entrance toward a loading exit of the inspection device 10. In this case, the first conveyance unit 41 and the second conveyance unit 42 can adopt a system combining pulleys and belts (conveyor belt system) or a system constituted of pulleys. For example, when the first conveyance unit 41 and the second conveyance unit 42 are conveying apparatuses of a conveyor belt system, the first conveyance unit 41 is constituted of: a first conveyor belt 41a that supports, from below, both ends of the inspection object 12 in the Y direction and moves the inspection object 12 placed on an upper surface of the belt from the loading entrance to the imaging area; and a first driving unit 41b that drives the first conveyor belt 41a. In addition, the second conveyance unit 42 is constituted of: a second conveyor belt 42a that supports, from below, both ends of the inspection object 12 in the Y direction delivered from the first conveyance unit 41, moves the inspection object 12 placed on an upper surface of the belt to the inspection/count area, and further moves the inspection object 12 outside from the loading exit; and a second driving unit 42b that drives the second conveyor belt 42a. The first driving unit 41b and the second driving unit 42b are configured to operate independently of each other according to command signals from the controlling unit 30.

In addition, the conveying unit 40 is provided with a clamping mechanism constituted of a fixing unit 44 and a movable unit 45 in the imaging area. In the configuration shown in Figure 2, the clamping mechanism is constituted of the fixing unit 44 that grasps at least two points at each of both ends of the inspection object 12 in the Y direction positioned in the imaging area and the movable unit 45 that lifts the inspection object 12 from below and fixes the inspection object 12 by sandwiching the inspection object 12 between itself and the fixing unit 44. The clamping mechanism shown here is simply an example and, alternatively, a configuration may be adopted in which the first conveyance unit 41 is moved upward instead of the movable unit 45 and the inspection object 12 is fixed by sandwiching the inspection object 12 between the first conveyance unit 41 and the fixing unit 44. Alternatively, a configuration may be adopted in which a fixing unit is provided below the inspection object 12 and a movable unit arranged above the inspection object 12 is moved downward to fix the inspection object 12 by sandwiching the inspection object 12 between the movable unit and the fixing unit. Alternatively, the inspection object 12 may be adsorbed and fixed instead of fixing the inspection object 12 by sandwiching the inspection object 12 between the fixing unit 44 and the movable unit 45.

Next, processing of an inspection of the inspection object 12 by the inspection device 10 according to the first embodiment will be described using Figure 3.

### - In Case of One Conveyance Unit -

First, a case where the conveying unit 40 is constituted of one conveyance unit will be described using Figure 3(a). As described above, while the conveying unit 40 is constituted of two conveyance units (the first conveyance unit 41 and the second conveyance unit 42) in the inspection device 10 according to the present embodiment, since the conveyance units are operated according to command signals from the controlling unit 30, operating the two conveyance units 41 and 42 as being integrated enables the two conveyance units 41 and 42 to be handled as one conveyance unit as a whole.

When the inspection object 12 is delivered to the inspection device 10 from the loading entrance, the controlling unit 30 operates the first conveyance unit 41 and the second conveyance unit 42, carries the inspection object 12 into the imaging area in the inspection device 10, and fixes the inspection object 12 with the fixing unit 44 and the movable unit 45 (step S101). In this case, the imaging area is a range where the imaging unit 20 is moved by the XY stage 16 and an image of at least a part of the inspection object 12 can be captured. When the field of view (FOV) of the first image unit 21 and the second image unit 23 of the imaging unit 20 is smaller than the inspection object 12, by compositing partial image data obtained by capturing a plurality of partial images of the inspection object 12 while moving the imaging unit 20 with the XY stage 16, an entire image of the inspection object 12 (full substrate image data) can be acquired.

Once the inspection object 12 is fixed by the fixing unit 44 and the movable unit 45 in the imaging area, the controlling unit 30 moves the imaging unit 20 by the XY stage 16 to acquire partial image data of the inspection object 12 and stores the partial image data in the memory 35 (step S102). The controlling unit 30 moves the imaging unit 20 and repeats imaging processing until pieces of partial image data that cover the entire inspection object 12 are acquired. When image data (full substrate image data) of the entire inspection object 12 is acquired as a plurality of pieces of partial image data in this manner, inspections can be sequentially performed using the acquired pieces of partial image data. Therefore, the controlling unit 30 reads the acquired pieces of partial image data from the memory 35 and performs inspection processing using the read pieces of partial image data in parallel with the imaging processing described above (step S103).

When the controlling unit 30 determines that all pieces of partial image data of the inspection object 12 have been acquired, the controlling unit 30 releases the fixation of the inspection object 12 by the fixing unit 44 and the movable unit 45 and drives the first conveyance unit 41 and the second conveyance unit 42 to move the inspection object 12 to the inspection/count area (step S104). On the other hand, when a defect is found as a result of the inspection, a visual inspection or the like may be executed. When the visual inspection is executed, the inspection object 12 having completed the imaging processing is not immediately carried out to the next step but must stand by for a while. Therefore, the inspection object 12 having completed the imaging processing is caused to stand by in the inspection/count area (step S105). When the visual inspection is not executed and preparations for processing of a next latter stage are completed, the inspection object 12 is carried out without having to stand by. In addition, when the inspection processing ends, the controlling unit 30 performs count processing for outputting a result of the inspection processing (step S106). The counted results are outputted to the output unit 37, the memory 35, or an external storage apparatus (not illustrated). Furthermore, as described above, full substrate image data is generated using partial image data stored in the memory 35 and outputted to the output unit 37, the memory 35, or the external storage apparatus. When the count processing ends and the controlling unit 30 determines that there is no abnormality in the inspection result, the controlling unit 30 operates the first conveyance unit 41 and the second conveyance unit 42 and carries out the inspection object 12 to a next step (step S107). There may be cases where an inspection result and full substrate image data of the inspection object 12 are outputted in the count processing. Therefore, when the imaging processing and the inspection processing are to be executed in parallel, the memory 35 must have enough capacity to store at least all of the pieces of partial image data of the entire inspection object 12.

In addition, when the inspection object 12 of which an inspection has ended is carried out to the next step, the controlling unit 30 carries the next inspection object 12 into the imaging area by the first and second conveyance units 41 and 42 (step S111), performs imaging processing (step S112), and executes inspection processing (step S113). Once the imaging processing ends, the controlling unit 30 moves the inspection object 12 to the inspection/count area by the first and second conveyance units 41 and 42 (step S114), and causes the inspection object 12 to stand by (step S115). Furthermore, when the inspection processing ends, count processing is executed (step S116), and when the controlling unit 30 determines that there is no abnormality in post-inspection processing such as a visual determination, the controlling unit 30 carries out the inspection object 12 to a next step by the first and second conveyance units 41 and 42 (step S117). The controlling unit 30 repeats the same processing for the subsequent inspection objects 12.

As described above, when the conveying unit 40 has one conveyance unit (in the case of the present embodiment, when the two conveyance units are operated in an integrated manner), since the next inspection object 12 can be carried in only after the inspection object 12 currently been inspected is carried out to the next step, as shown in Figure 3(a), the time (takt time) required for inspection of one inspection object 12 is T1 from start of loading to end of unloading.

### - In Case of Two Conveyance Units -

Next, a case where the conveying unit 40 is constituted of two conveyance units 41 and 42 that are arranged in series and operated individually will be described using Figure 3(b). Note that the processing of inspection is the same as the case of one conveyance unit.

When the inspection object 12 is delivered to the inspection device 10 from the loading entrance, the controlling unit 30 operates the first conveyance unit 41, carries the inspection object 12 into the imaging area in the inspection device 10, and fixes the inspection object 12 with the fixing unit 44 and the movable unit 45 (step S201). Once the inspection object 12 is fixed in the imaging area, the controlling unit 30 moves the imaging unit 20 by the XY stage 16 to acquire partial image data of the inspection object 12 and stores the partial image data in the memory 35 (step S202). The controlling unit 30 repeats imaging processing until pieces of partial image data of the entire inspection object 12 are acquired. In addition, the controlling unit 30 reads the acquired pieces of partial image data from the memory 35 and performs inspection processing using the read pieces of partial image data in parallel with the imaging processing described above (step S203). Furthermore, when the controlling unit 30 determines that all pieces of partial image data of the inspection object 12 have been acquired, the controlling unit 30 releases the fixation of the inspection object 12 by the fixing unit 44 and the movable unit 45 and operates the first conveyance unit 41 and the second conveyance unit 42 to move the inspection object 12 to the inspection/count area (step S204), and places the inspection object 12 in a standby state (step S205). In addition, when the inspection processing ends, the controlling unit 30 performs count processing for outputting a result of the inspection processing (step S206). The counted results are outputted to the output unit 37, the memory 35, or an external storage apparatus. When the controlling unit 30 determines that there is no abnormality in the inspection object 12 as a result of the count processing, the controlling unit 30 operates the second conveyance unit 42 and carries out the inspection object 12 to a next step (step S207).

On the other hand, at a time point where the imaging processing of the inspection object 12 currently being inspected ends, the inspection object 12 has been moved to the inspection/count area and is standing by. In this case, when the inspection object 12 is standing by in the inspection/count area, the first conveyance unit 41 is not being used. Therefore, before the inspection processing of the inspection object 12 currently being inspected ends, the controlling unit 30 operates the first conveyance unit 41 and carries the next inspection object 12 into the imaging area (step S211), once the inspection processing of the inspection object 12 currently being inspected ends, executes imaging processing with respect to the next inspection object 12 (step S212), and executes inspection processing in parallel with the imaging processing (step S213). By moving the inspection object 12 to the inspection/count area immediately after imaging, the imaging of the next inspection object 12 can be started without having to wait until the inspection processing of the previous inspection object 12 ends. In addition, when the imaging processing of the next inspection object 12 ends, the controlling unit 30 operates the first conveyance unit 41 and the second conveyance unit 42 on the condition that the previous inspection object 12 has been carried out and moves the next inspection object 12 to the inspection/count area (step S214), and places the inspection object 12 in a standby state (step S215). Furthermore, the controlling unit 30 executes count processing once the inspection processing ends (step S216), and when the controlling unit 30 determines that there is no abnormality in the inspection object 12 as a result of the count processing, the controlling unit 30 operates the second conveyance unit 42 and carries out the inspection object 12 to a next step (step S217).

As described above, when the conveying unit 40 has two conveyance units, inspection processing can be started once imaging processing of the previous inspection object 12 ends, and the previous inspection object 12 can be moved from the imaging area to the inspection/count area in parallel with the inspection processing. In addition, since loading of the next inspection object 12 can be performed in parallel with the execution of the inspection processing of the previous inspection object 12 and unloading of the previous inspection object 12 can be performed when the imaging processing of the next inspection object 12 is being executed, as shown in Figure 3(b), time required from start of loading of the previous inspection object 12 to start of loading of the next inspection object 12 is T2. The time T2 can be made shorter than the time (takt time) T1 required by inspection of one inspection object 12 when there is one conveyance unit. Furthermore, as is obvious from Figure 3(b), since the count processing of the previous inspection object 12 and the imaging processing of the next inspection object 12 can be executed in parallel, time that is twice T2 being the time required to inspect two inspection objects 12 is shorter than time that is twice T1 being the time required to inspect two inspection objects 12 when there is one conveyance unit and, consequently, overall takt time can be reduced. In such a configuration, when the inspection processing of the next inspection object 12 and the count processing of the previous inspection object 12 are to be performed simultaneously, the memory 35 desirably has a capacity to store pieces of partial image data covering the entirety of two inspection objects 12.

### - In Case of Inspecting Inspection Objects 12 of Different Lengths -

When performing inspections of inspection objects 12 of different lengths in the X direction, with respect to the inspection object 12 that fits into the inspection/count area (when a length La of the inspection object 12 in the X direction (a length in a direction in which the inspection object 12 is conveyed) is shorter than a length L2 of the inspection/count area), the controlling unit 30 operates the conveying unit 40 as two conveyance units (hereinafter, referred to as a "2-buffer mode"), and with respect to the inspection object 12 that does not fit into the inspection/count area (when the length La of the inspection object 12 in the X direction is longer than the length L2 of the inspection/count area), the controlling unit 30 operates the conveying unit 40 as one conveyance unit (hereinafter, referred to as a "standard mode"). As a length L1 of the imaging area in the X direction, a length equal to or longer than a length of the largest inspection object 12 among the inspection objects 12 to be inspected is necessary. Since the substrate inspection data described above also includes the length of the inspection object 12 (the length La in the X direction), the controlling unit 30 can determine the length of the inspection object 12 to be inspected next based on the substrate inspection data of the inspection object 12 and determine whether to operate the conveying unit 40 in the standard mode or in the 2-buffer mode. Accordingly, even when there is a mixture of inspection objects 12 of different lengths, since the controlling unit 30 can determine the operating mode of the conveying unit 40, time (takt time) required for inspection of each inspection object 12 can be optimized and, consequently, the throughput of the inspection device 10 can be improved.

### - Modification of First Embodiment -

As described above, when a defect is found in the inspection object 12 as a result of the inspection and count, a visual inspection may be implemented. After the imaging processing ends, the inspection object 12 has been moved to the inspection/count area by the conveying unit 44. Therefore, the inspection/count area of the inspection device 10 may be provided with an imaging unit that is separate from the imaging unit 20 described above and the control unit 30 may be configured to perform a visual inspection using the imaging unit.

In addition, while a case where the imaging unit 20 is arranged on a side of the loading entrance and used as an imaging area and the side of the loading exit is used as the inspection/count area where the inspection object 12 is to stand by, the loading entrance side (side of the first conveyance unit 41) may be used as the standby area where the inspection object 12 is to stand by and the loading exit side (side of the second conveyance unit 42) may be used as the imaging area where the imaging unit 20 is to be arranged and imaging, inspection, and count are to be performed. In this case, a third conveyance unit (not illustrated) may be arranged on a side of a conveyance port of the second conveyance unit 42 and the side of the second conveyance unit 42 may be used as the imaging area and the side of the third conveyance unit may be used as the inspection/count area. When time required by an inspection by the inspection device 10 is longer than time required by a step on the upstream side of the inspection device 10, the takt time can be reduced by providing the standby area on an upstream side (side of the loading entrance) of the imaging area.

Alternatively, the third conveyance unit (not illustrated) may be arranged on a side of the loading entrance of the first conveyance unit 41, the side of the first conveyance unit 41 may be used as the imaging area and the side of the second conveyance unit may be used as the inspection/count area, and the side of the third conveyance unit may be used as a flipper machine that flips the inspection object 12.

### (Second embodiment)

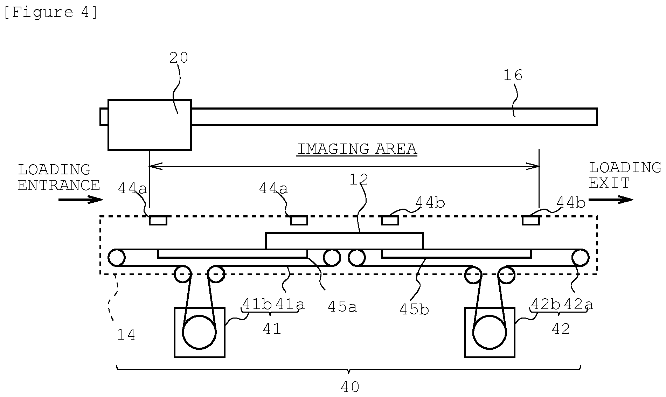

A second embodiment of the conveying unit 40 will be described with reference to Figure 4. The conveying unit 40 according to the second embodiment is configured to have two conveyance units (the first conveyance unit 41 and the second conveyance unit 42) arranged in series from the side of the loading entrance toward the side of the loading exit in a similar manner to the first embodiment. In addition, the first conveyance unit 41 is provided with a clamping mechanism constituted of a fixing unit 44a and a movable unit 45b and the second conveyance unit 42 is provided with a clamping mechanism constituted of a fixing unit 44b and the movable unit 45b.

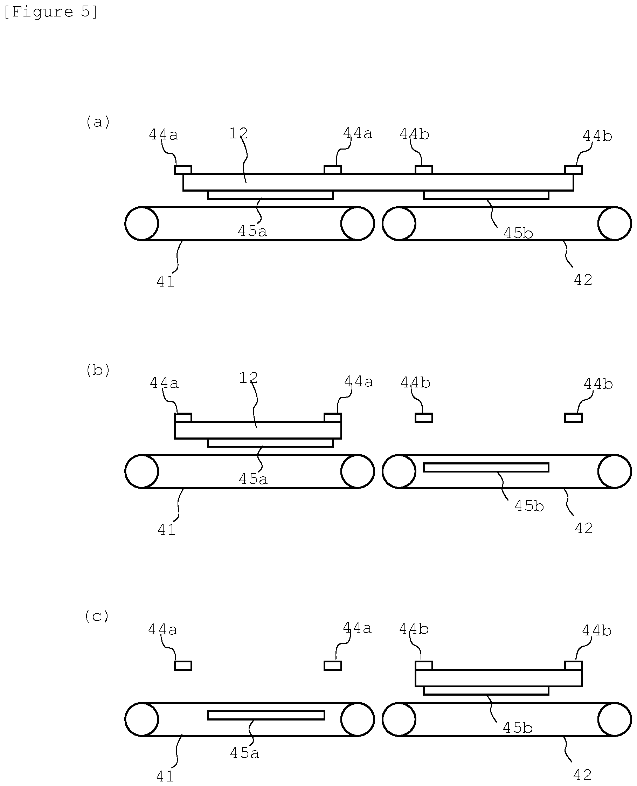

In the second embodiment, the imaging area is set so as to straddle the first conveyance unit 41 and the second conveyance unit 42. In addition, the imaging unit 20 is configured to be movable from above the first conveyance unit 41 to above the second conveyance unit 42 by the XY stage 16. Therefore, in the second embodiment, operations of the first and second conveyance units 41 and 42 and the fixation of the inspection object 12 by the fixing unit 44 and the movable unit 45 can be switched and controlled by the controlling unit 30 depending on a length of the inspection object 12, time required by imaging processing, inspection processing, or count processing, or a status of a step in a preceding stage or a subsequent stage of the inspection device 10. Hereinafter, control of the conveying unit 40 by the controlling unit 30 will be described using Figure 5. While the lengths of the first conveyance unit 41 and the second conveyance unit 42 in the X direction will be described as being the same below, the lengths need not be the same as described in the first embodiment. In addition, processing performed with respect to one inspection object 12 is as described in the first embodiment. Furthermore, the first conveyance unit 41 and the second conveyance unit 42 are represented in a simple manner in Figure 5.

First, when a length of the inspection object 12 in the X direction is longer than a length of an effective area of the first conveyance unit 41 or the second conveyance unit 42 in the X direction, the controlling unit 30 operates the first conveyance unit 41 and the second conveyance unit 42 in the standard mode. In this case, as shown in Figure 5(a), the inspection object 12 is carried into a central part of the imaging area and fixed by the fixing units 44a and 44b and the movable units 45a and 45b.

On the other hand, when the length of the inspection object 12 in the X direction is equal to or shorter than the lengths of the first conveyance unit 41 and the second conveyance unit 42 in the X direction, the controlling unit 30 operates the first conveyance unit 41 and the second conveyance unit 42 in the 2-buffer mode. In this case, as shown in Figure 5(b), the side of the first conveyance unit 41 may be used as the imaging area and the side of the second conveyance unit 42 may be used as the standby area (inspection/count area) or, as shown in Figure 5(c), the side of the first conveyance unit 41 may be used as the standby area and the side of the second conveyance unit 42 may be used as the imaging area (inspection and count are to be also performed in this area). When the side of the first conveyance unit 41 is used as the imaging area, the inspection object 12 fixes the inspection object 12 by the fixing unit 44a and the movable unit 45a arranged on the side of the first conveyance unit 41. In addition, when the side of the second conveyance unit 42 is used as the imaging area, the inspection object 12 fixes the inspection object 12 by the fixing unit 44b and the movable unit 45b arranged on the side of the second conveyance unit 42.

As described in the first embodiment, when the inspection/count processing of the inspection object 12 takes more time than the imaging processing of the inspection object 12, the takt time for inspecting the inspection object 12 can be reduced by using the side of the first conveyance unit 41 as the imaging area. On the other hand, if the productivity of a step on an upstream side of the inspection device 10 is to be improved, the takt time can be reduced by using the side of the first conveyance unit 41 as the standby area and using the side of the second conveyance unit 42 as the imaging area. The controlling unit 30 can switch between adopting the standard mode and adopting the 2-buffer mode depending on the length of the inspection object 12 obtained from substrate inspection data or the time required by each processing step and, in the case of the 2-buffer mode, the controlling unit 30 can select whether to use the side of the first conveyance unit 41 or the side of the second conveyance unit 42 as the imaging area. Accordingly, the takt time for inspection of each inspection object 12 can be optimized and, consequently, the throughput of the inspection device 10 can be improved.

### (Third embodiment)

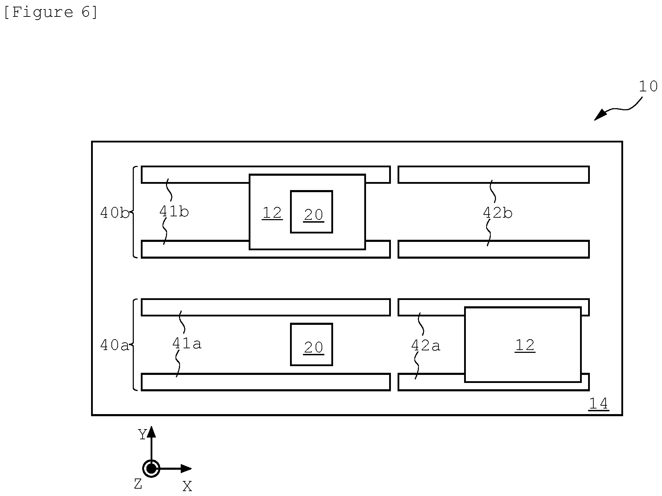

The conveying unit 40 according to the first embodiment and the second embodiment described above is also useful for a so-called dual-lane inspection device 10 in which two conveying units 40a and 40b are provided side-by-side as shown in Figure 6. In other words, this is a configuration in which each of the two conveying units 40a and 40b has two lanes constituted of first conveyance units 41a and 41b and second conveyance units 42a and 42b. In a third embodiment, while one imaging unit 20 may be provided in common for the two lanes, providing the imaging unit 20 for each lane as shown in Figure 6 enables a greater effect to be produced when operating the conveying unit 40 in the 2-buffer mode. Specifically, by providing the imaging unit 20 in each lane, processing of loading and imaging and processing of inspection/count and unloading can be performed by the respective lanes without creating wait time for imaging by the imaging unit 20, the takt time for inspection of each inspection object 12 can be optimized, and a throughput of the entire inspection device 10 can be improved.

### Reference Signs List

- 10: inspection device
- 20: imaging unit (image unit)
- 30: controlling unit (control unit)
- 35: memory
- 40: conveying unit
- 41: first conveyance unit
- 42: second conveyance unit

## Claims

1. An inspection device, comprising:
an image unit that acquires image data of an inspection object;
a conveying unit that moves the inspection object; and
a control unit that controls operations of the image unit and the conveying unit, wherein
the conveying unit includes at least two conveyance units connected in series in a moving direction in which the inspection object is moved,
an operation of each of the conveyance units can be individually controlled by the control unit,
at least one conveyance unit of the conveyance units is a first conveyance unit arranged in an imaging area where image data can be acquired by the image unit,
at least one conveyance unit of the remaining conveyance units is a second conveyance unit arranged in a standby area in front of or behind the imaging area in the moving direction, and
the control unit causes,
when the control unit is individually controlling the conveyance units,
when the image unit is capturing an image of the inspection object having been moved to the imaging area by the first conveyance unit, the second conveyance unit to load another inspection object into the standby area or unload another inspection object from the standby area.

2. The inspection device according to claim 1, wherein
the control unit
compares a length of the inspection object in the moving direction and lengths of the conveyance units in the moving direction with each other,
when the length of the inspection object is longer than the length of any of the conveyance units, controls operations of all of the conveyance units as one conveyance unit, and
when the length of the inspection object is equal to or shorter than the length of any of the conveyance units, controls operations of the conveyance units individually.

3. The inspection device according to claim 1 or 2, wherein
when the standby area is behind the imaging area, the standby area has an image unit for visual inspection, and
the control unit acquires image data of the inspection object by the image unit for visual inspection when the inspection object is moved to the standby area.

4. The inspection device according to claim 1 or 2, wherein
when the standby area is in front of the imaging area, the standby area is provided with a flipper machine.

5. The inspection device according to claim 1 or 2, wherein
the control unit has a memory with a capacity that enables at least one image of an entirety of the inspection object to be stored.

6. An inspection device, comprising:
an image unit that acquires image data of an inspection object;
a conveying unit that moves the inspection object; and
a control unit that controls operations of the image unit and the conveying unit, wherein
the conveying unit includes at least two conveyance units connected in series in a moving direction in which the inspection object is moved,
an operation of each of the conveyance units can be individually controlled by the control unit,
at least two conveyance units of the conveyance units are a first conveyance unit and a second conveyance unit arranged in an imaging area where image data can be acquired by the image unit, and
the control unit causes,
when the control unit is individually controlling the conveyance units,
when an image of the inspection object in one of the first conveyance unit and the second conveyance unit is being captured by the image unit, another inspection object to be moved by the other of the first conveyance unit and the second conveyance unit.

7. The inspection device according to claim 6, wherein
the control unit selects, when loading the inspection object, a conveyance unit to perform imaging of the inspection object from the first conveyance unit and the second conveyance unit.

8. The inspection device according to claim 6 or 7, wherein
the control unit
compares a length of the inspection object in the moving direction and lengths of the first conveyance unit and the second conveyance unit in the moving direction with each other,
when the length of the inspection object is longer than the length of any of the first conveyance unit and the second conveyance unit, controls operations of the first conveyance unit and the second conveyance unit as one conveyance unit, and
when the length of the inspection object is equal to or shorter than the length of any of the first conveyance unit and the second conveyance unit, controls operations of the first conveyance unit and the second conveyance unit individually.

9. The inspection device according to claim 6 or 7, wherein
the control unit has a memory with a capacity that enables at least one image of an entirety of the inspection object to be stored.
